# EUROPEAN PATENT SPECIFICATION

(11) **EP 3 070 790 B1**
(45) Date of publication and mention of the grant of the patent: **17.11.2021**
(21) Application number: 16159460.1
(22) Date of filing: 09.03.2016
(51) Int. Cl.: H01S 3/06, H01S 3/113, H01S 5/042, H01S 5/183, H01S 5/32, H01S 5/343, H01S 3/094, H01S 5/42

(54) **SURFACE-EMITTING LASER, SURFACE-EMITTING LASER ARRAY, LASER APPARATUS, IGNITION DEVICE AND INTERNAL COMBUSTION ENGINE**
OBERFLÄCHENEMITTIERENDER LASER, OBERFLÄCHENEMITTIERENDES LASERARRAY, LASERVORRICHTUNG, ZÜNDUNGSVORRICHTUNG UND VERBRENNUNGSMOTOR
LASER À ÉMISSION DE SURFACE, RÉSEAU LASER À ÉMISSION DE SURFACE, APPAREIL LASER, DISPOSITIF D'ALLUMAGE ET MOTEUR À COMBUSTION INTERNE

(30) Priority: 16.03.2015 JP 2015051565; 26.08.2015 JP 2015166740
(43) Date of publication of application: 21.09.2016
(73) Proprietor: Ricoh Company, Ltd., Tokyo 143-8555 (JP)
(72) Inventor: OKURA, Yusuke, Tokyo, 143-8555 (JP); JIKUTANI, Naoto, Tokyo, 143-8555 (JP); IZUMIYA, Kazuma, Tokyo, 143-8555 (JP); HARADA, Shinichi, Tokyo, 143-8555 (JP)
(74) Representative: J A Kemp LLP

(56) References cited:
- EP-A1- 1 780 849
- US-A1- 2006 245 459
- US-A1- 2008 212 630
- YAN ZHANG ET AL: "Design and comparison of GaAs, GaAsP and InGaAlAs quantum-well active regions for 808-nm VCSELs", OPTICS EXPRESS OPTICAL SOCIETY OF AMERICA USA, vol. 19, no. 13, 2011, pages 12569-12581, XP002760110, ISSN: 1094-4087
- WINTNER E ET AL: "Laser plasma ignition: status, perspectives, solutions", OPTOMECHATRONIC MICRO/NANO DEVICES AND COMPONENTS III : 8 - 10 OCTOBER 2007, LAUSANNE, SWITZERLAND; [PROCEEDINGS OF SPIE , ISSN 0277-786X], SPIE, BELLINGHAM, WASH, vol. 9065, 28 November 2013 (2013-11-28), pages 90650B-90650B, XP060032353, DOI: 10.1117/12.2053152 ISBN: 978-1-62841-730-2
- None

## Description

### BACKGROUND OF THE INVENTION

### 1. Field of the Invention

The disclosures herein generally relate to a surface-emitting laser, a surface-emitting laser array, a laser apparatus, an ignition device and an internal combustion engine, and more particularly, to a vertical cavity surface-emitting laser, a surface-emitting laser array having the plurality of surface-emitting lasers, a laser apparatus having the surface-emitting laser array, and an ignition device and an internal combustion engine each provided with the laser apparatus.

### 2. Description of the Related Art

A vertical cavity surface emitting laser (VCSEL) is a laser that emits light in a direction orthogonal to a substrate. Recently, the VCSEL has received attention due to its low cost, its low power consumption, its small size, being suitable for a two-dimensional device and its high performance, compared with an edge emitting semiconductor laser device that emits light in a direction parallel to a substrate.

For example, Japanese Unexamined Patent Application Publication No. 2013-191784 discloses a surface-emitting semiconductor laser including a substrate; a first semiconductor multi-layer reflection mirror; a semi-insulating i-type AlGaAs layer having an optical film thickness greater than an oscillation wavelength; an n-type semiconductor layer, not having a deep level due to an impurity, or the deep level being higher than a Γ level, and capable of having a lattice matching with the substrate; an active region; a second semiconductor multi-layer reflection mirror; an n-side first electrode electrically connected to the semiconductor layer; and a p-side second electrode electrically connected to the second semiconductor multi-layer reflection mirror.

Moreover, M. Tsunekane and T. Taira, "VCSEL excitation micro laser for engine ignition aiming at extending operation temperature range", 32nd Annual Meeting of the Laser Society of Japan, B330p I 16, pp. 33, 2012 discloses a laser for engine ignition having a surface-emitting laser.

Moreover, Y. Zhang et al., "Design and comparison of GaAs, GaAsP and InGaAlAs quantum-well active regions for 808-nm VCSELs", Optics Express, Vol. 19, No. 13, pp. 12569-12581 (2011) discloses results of comparison for cases where a quantum well layer of an active layer in a surface-emitting laser having an oscillation wavelength of 808 nm is GaAs, GaAsP or InGaAlAs.

US 2006/0245459A1 discloses a VCSEL including an AlGaAs based active layer and AlₐGa_{b}In_{1-a-b}P (where 0≤a≤1, 0≤b≤1 and 0≤a+b ≤1) layers formed at least one of above and below the active layer.

EP1780849 A discloses a surface emission laser diode, in which a part of the spacer layers is formed of (AlₐGa₁₋ₐ)_{b}In_{1-b}P (0≤a≤1, 0≤b≤1) and in which quantum well layers of Ga_{c}In_{1-c}P_{d}As_{1-d} (0≤c≤1, 0≤d≤1) and barrier layers of GaₑIn₁₋ₑP_{f}As_{1-f} (0≤e≤1, 0≤f≤1) are formed.

US 2008/0212630 A1 and WINTNER ["Laser plasma ignition: status, perspectives, solutions", Optomechatronic Micro/Nano Devices and Components III: 8-10 October 2007, Lausanne, Switzerland, Proceedings of the SPIE, vol. 9065, 28 November 2013, pages 90650B-90650B] disclose background art.

### SUMMARY OF THE INVENTION

It is a general object of present invention to provide a surface-emitting laser, a surface-emitting laser array, a laser apparatus, an ignition device and an internal combustion engine that substantially obviates one or more problems caused by the limitations and disadvantages of the related art. The invention is defined in claim 1, preferred embodiments are disclosed in the dependent claims.

### BRIEF DESCRIPTION OF THE DRAWINGS

Other objects and further features of embodiments will become apparent from the following detailed description when read in conjunction with the accompanying drawings, in which:
FIG. 1 is a diagram for schematically explaining an engine 300 according to the embodiment;
FIG. 2 is a diagram for explaining an ignition device 301;
FIG. 3 is a diagram for explaining a laser resonator 206;
FIG. 4A is a plan view illustrating a light emitting part of a surface emitting laser array 201;
FIG. 4B is a cross-sectional view illustrating the light emitting part of the surface emitting laser array cut along a line A-A;
FIGs. 5A and 5B are diagrams for explaining a substrate of the surface-emitting laser array 201, respectively;
FIG. 6 is a diagram illustrating an active layer 105;
FIG. 7 is a diagram for explaining a first example of a manufacturing method for the surface-emitting laser array 201;
FIG. 8 is a diagram for explaining a second example of the manufacturing method for the surface-emitting laser array 201;
FIG. 9 is a diagram for explaining a third example of the manufacturing method for the surface-emitting laser array 201;
FIG. 10 is a diagram for explaining a fourth example of the manufacturing method for the surface-emitting laser array 201;
FIG. 11 is a diagram for explaining a fifth example of the manufacturing method for the surface-emitting laser array 201;

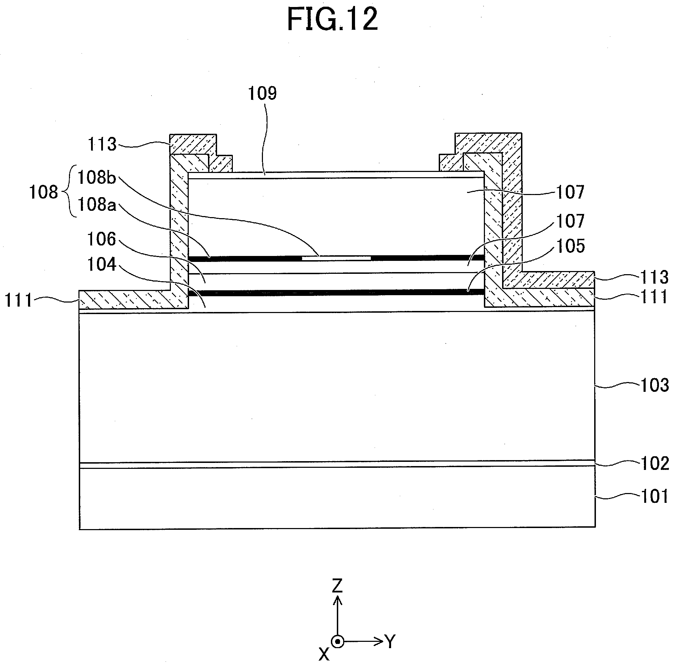

FIG. 12 is a diagram for explaining a sixth example of the manufacturing method for the surface-emitting laser array 201;
FIG. 13 is a diagram for explaining a seventh example of the manufacturing method for the surface-emitting laser array 201;
FIGs. 14A and 14B are diagrams for schematically explaining a configuration of a laser annealing device, respectively; and
FIG. 15 is a diagram for schematically explaining a configuration of a laser processing machine.

### DESCRIPTION OF THE PREFERRED EMBODIMENTS

### [Outline]

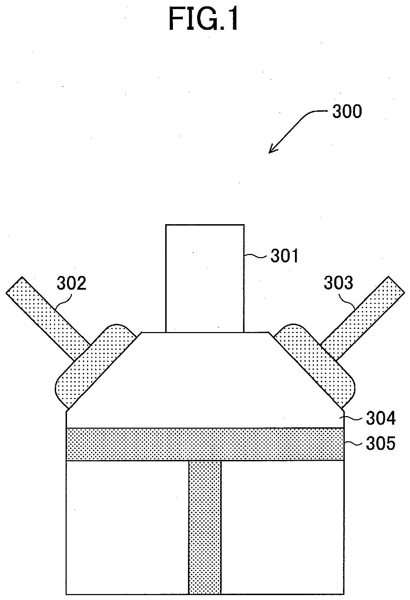

In the following, an embodiment of the present invention will be described with reference to drawings. FIG. 1 is a diagram schematically illustrating a main part of an engine 300 as an internal combustion engine according to the embodiments.

The engine 300 includes an ignition device 301, a fuel injection mechanism 302, an exhaust mechanism 303, a combustion chamber 304, a piston 305 and the like.

An operation of the engine 300 will be briefly described as follows:
(1) The fuel injection mechanism 302 injects a combustible mixture gas of fuel and air into the combustion chamber 304 (intake);
(2) The piston 305 rises and compresses the combustible mixture gas (compression);
(3) The ignition device 301 emits laser light to the inside of the combustion chamber 304. Then, the fuel is ignited (ignition);
(4) A combustion gas is generated and the piston 305 descends (combustion); and
(5) The exhaust mechanism 303 exhausts the combustion gas to the outside of the combustion chamber 304 (emission).

In this way, a set of processes including intake, compression, ignition, combustion and emission is repeated. Then, the piston 305 moves corresponding to the change in volume of the gas in the combustion chamber 304, and kinetic energy is generated. As the fuel, for example, natural gas, gasoline or the like is used.

Meanwhile, the engine 300 performs the above-described operation based on instructions by an engine control device, which is arranged outside the engine 300 and electrically coupled to the engine 300.

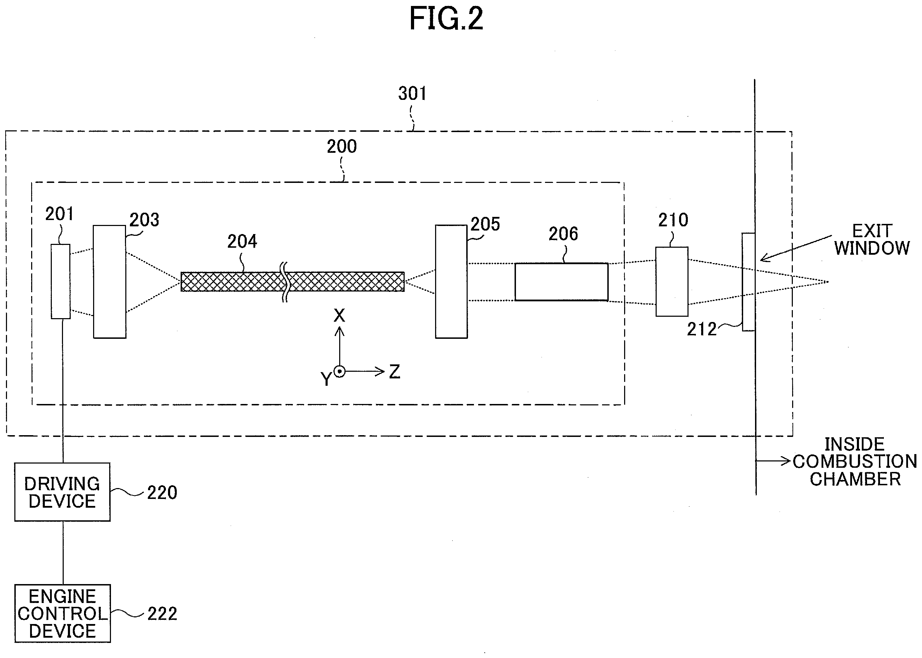

The ignition device 301 includes, for example, as shown in FIG. 2, a laser device 200, an emission optical system 210, a protection member 212 and the like. To the ignition device 301, a driving device 220 and an engine control device 222 are coupled.

The emission optical system 210 condenses light emitted from the laser device 200. Therefore, at a condensing point, high energy density can be obtained.

The protection member 212 is a transparent window arranged facing the combustion chamber 304. Here, for example, sapphire glass is used as a material of the protection member 212.

The laser device 200 includes a surface emitting laser array 201, a first condensing optical system 203, an optical fiber 204, a second condensing optical system 205 and a laser resonator 206. Meanwhile, in the specification of the present application, a xyz three-dimensional orthogonal coordinate system is used, and the description will be performed assuming that the emission direction of light from the surface-emitting laser array 201 is +z-direction.

The surface-emitting laser array 201 is a light source for excitation and includes a plurality of light emitting parts. Each of the light emitting parts is a vertical cavity surface emitting laser (VCSEL).

According to the feature of quite small deviation of wavelength of emitted light due to temperature, a surface-emitting laser array is a favorable light source for exciting a Q switch laser, a characteristic of which may drastically change due to wavelength deviation. Therefore, the surface-emitting laser array has an advantage that it becomes simple to control environmental temperature in a case of using for a light source for excitation.

The first condensing optical system 203 condenses light emitted from the surface-emitting laser array 201.

The optical fiber 204 is arranged so that a center of an end face of a core on the -Z side is positioned at a spot where light is condensed by the first condensing optical system 203.

According to the optical fiber 204 arranged as above, the surface-emitting laser array 201 can be arranged at a position separated from the laser resonator 206. Therefore, it becomes possible to increase a degree of freedom for arrangement design. Moreover, since a heat source can be moved away from the surface-emitting laser array 201 in a case of using the laser device 200 for an ignition device, it becomes possible to increase a range of a method for cooling the engine 300.

Light entering the optical fiber 204 propagates in a core, and is emitted from the end face of the core on the +Z side.

The second condensing optical system 205 is arranged on an optical path of light emitted from the optical fiber 204, and condenses the light. Light condensed by the second condensing optical system 205 enters the laser resonator 206.

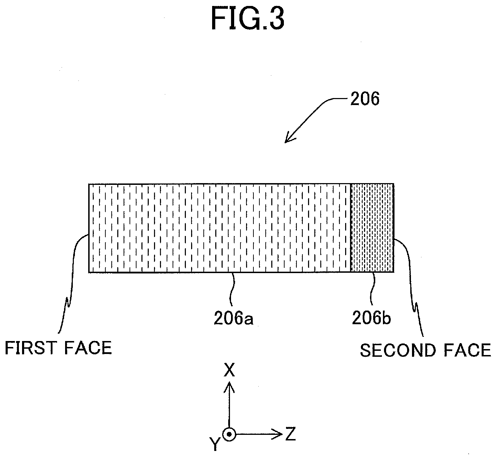

The laser resonator 206 is a Q switch laser, and includes, for example, as shown in FIG. 3, a laser medium 206a and a saturable absorber 206b.

The laser medium 206a is a Nd:YAG crystal having a rectangular parallelepiped shape with a resonator length of 8 mm. The saturable absorber 206b is a Cr:YAG crystal having a rectangular parallelepiped shape with a resonator length of 2 mm.

Meanwhile, here, the Nd:YAG crystal and the Cr:YAG crystal are joined to form a so-called composite crystal. Moreover, any of the Nd:YAG crystal and the Cr:YAG crystal are ceramics.

Light from the second condensing optical system 205 enters the laser medium 206a. That is, the laser medium 206a is excited by the light from the second condensing optical system 205. Meanwhile, wavelength of the light emitted from the surface-emitting laser array 201 is preferably 808 nm, which is a wavelength having the greatest absorption efficiency in a YAG crystal. Moreover, the saturable absorber 206b performs an operation for a Q switch.

A face of the laser medium 206a on an incident side (-Z side) and a face of the saturable absorber 206b on an emission side (+Z side) are subjected to an optical polishing treatment, and play roles of mirrors. Meanwhile, in the following, for the sake of simplicity, the face of the laser medium 206a on the incident side will also be called "first face", and the face of the saturable absorber 206b on the emission side will be called "second face" (See FIG. 3).

Furthermore, on the first face and the second face, dielectric films are coated depending on the wavelength of the light emitted from the surface-emitting laser array 201 and the wavelength of the light emitted from the laser resonator 206, respectively.

Specifically, the first face is subjected to a coating which exhibits sufficiently great transmission factor for light with a wavelength of 808 nm and exhibits sufficiently great reflectance for light with a wavelength of 1064 nm. Moreover, the second face is subjected to a coating exhibiting reflectance selected so that a desired threshold value can be obtained for light with a wavelength of 1064 nm.

According to the above-described configuration, light resonates and is amplified. Here, the resonator length of the laser resonator 206 is 10 mm, i.e. sum of 8 mm and 2 mm.

Returning to FIG. 2, the driving device 220 drives the surface-emitting laser array 201 based on an instruction of the engine control device 222. That is, the driving device 220 drives the surface-emitting laser array 201 so that light is emitted from the ignition device 301 at a timing of the ignition in the operation of the engine 300. Meanwhile, the plurality of light emitting parts in the surface-emitting laser array 201 turn on and off lights simultaneously.

In the embodiment, in a case where the surface-emitting laser array 201 is not required to be arranged at a position separated from the laser resonator 206, the optical fiber 204 may not be provided.

Moreover, here, the case of the engine (piston engine), in which the piston is moved by a combustion gas, as the internal combustion engine is described. This is not limiting. For example, a rotary engine, a gas turbine engine, or a jet engine may be used. It follows that the engine has only to combust fuel to generate a combustion gas.

Moreover, the ignition device 301 may be used in a cogeneration, which is a system of using exhaust heat to extract power, hot heat or cold heat, and thereby comprehensively enhancing energy efficiency.

Moreover, here, the case where the ignition device 301 is used in an internal combustion engine is described. However, this is not limiting.

Moreover, here, the case where the laser device 200 is used in an ignition device is described. However, this is not limiting. For example, the laser device 200 may be used in a laser processing machine, a laser peening device, a terahertz generation device or the like.

With the surface emitting laser of the related art, it is difficult to achieve both a high gain of the active layer and a high light emission efficiency.

According to the surface emitting laser of the embodiments, both the high gain of the active layer and the high light emission efficiency are achieved.

### [Details]

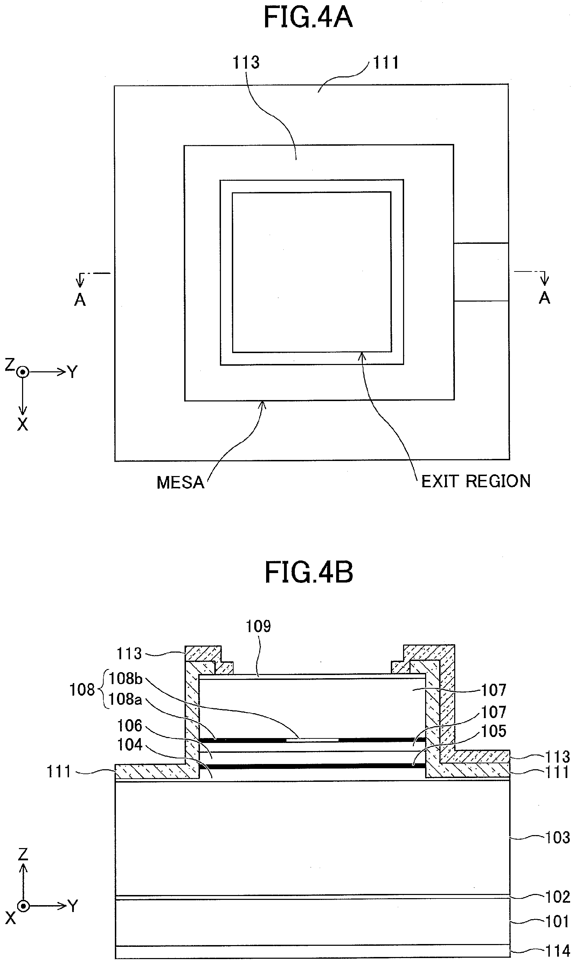

Next, details of the respective light emitting parts (surface-emitting laser) of the surface-emitting laser array 201 according to the embodiment will be described with reference to FIGs. 4A and 4B. Meanwhile, FIG. 4B is a cross-sectional view cut along A-A in FIG. 4A.

Each of the light emitting parts includes a substrate 101, a buffer layer 102, a lower semiconductor DBR (distribution Bragg reflector) 103, a lower spacer layer 104, an active layer 105, an upper spacer layer 106, an upper semiconductor DBR 107, a contact layer 109, a protection film 111, an upper electrode 113, a lower electrode 114 and the like.

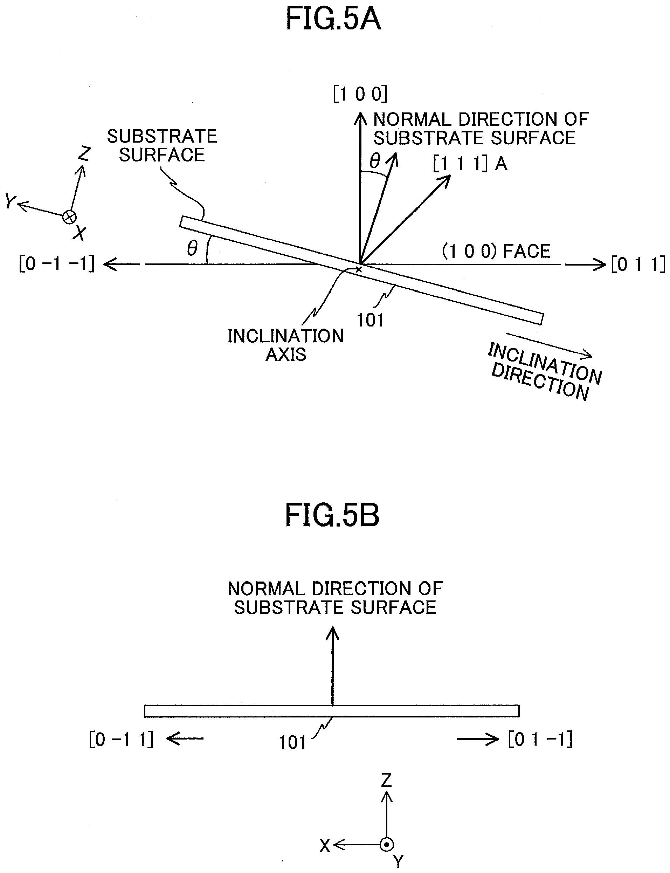

The substrate 101 is an n-GaAs single crystal substrate, a normal direction of surface of which is inclined with respect to a crystal orientation [1 0 0] direction toward a crystal orientation [1 1 1]A direction by 15 degrees (θ=15°), as shown in FIG. 5A. That is, the substrate 101 is a so-called inclined substrate. Here, as shown in FIG. 5B, the substrate is arranged so that a crystal orientation [0 - 1 1] direction is a +X direction and a crystal orientation [0 1 -1] direction is a -X direction. Then, an inclined axis of the inclined substrate is parallel to an X-axis direction. Meanwhile, a -Y direction will be also called "inclined direction".

Returning to FIG. 4B, the buffer layer 102 is laminated on a surface of the substrate 101 on the +Z side, and is a layer including n-GaAs.

The lower semiconductor DBR 103 is laminated on the buffer layer 102 on the +Z side, and includes 40.5 pairs of a low refraction index layer of n-Al_{0.9}Ga_{0.1}As (aluminum gallium arsenide) and a high refraction index layer of n-Al_{0.3}Ga_{0.7}As.

In order to reduce an electric resistance, composition gradient layers having thickness of 20 nm, composition of which changes gradually from one composition toward the other composition, are provided between the respective refraction index layers.

Moreover, from the buffer layer 102 to about the 37-th pair, the respective refraction index layers are set to have an optical thickness of λ/4, where λ is the oscillation wavelength, including a half of the adjacent composition gradient layer.

From there on, the optical thickness of the high refractive index layer is set to be λ/4 and the optical thickness of the lower refractive index layer is set to be 3λ/4, each including a half of the adjacent composition gradient layer.

Meanwhile, in a case where the optical thickness is λ/4, an actual thickness D of the layer is D=λ/4n, where n is the refraction index of medium of the layer.

The lower spacer layer 104 is laminated on the lower semiconductor DBR 103 on the +Z side, and is a non-doped (Al_{0.4}Ga_{0.8})_{0.5}In_{0.5}P (aluminum gallium indium phosphide) layer.

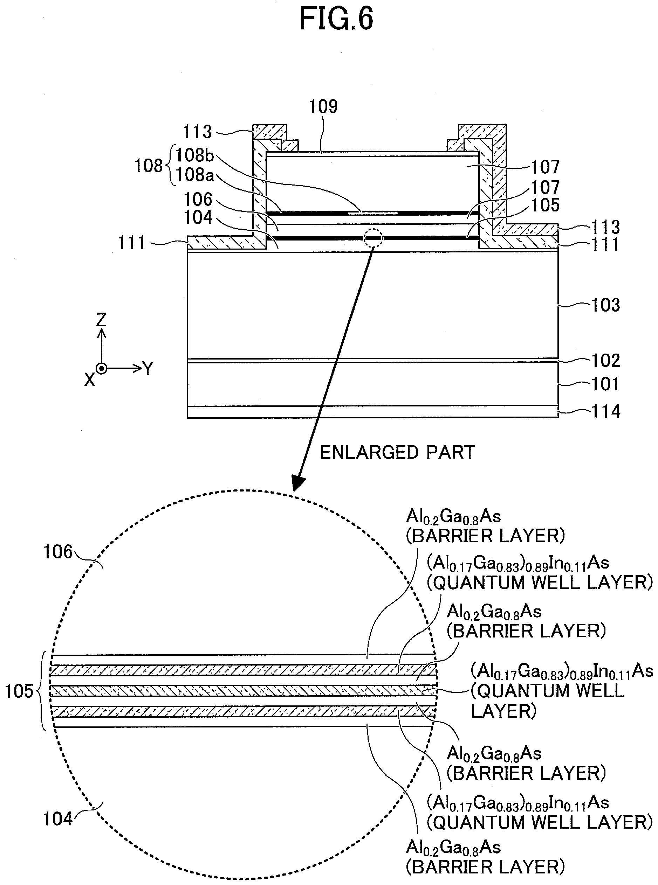

The active layer 105 is laminated on the lower spacer layer 104 on the +Z side, and has a triple quantum well (TQW) structure, in which a quantum well layer of (Al_{0.17}Ga_{0.83})_{0.89}In_{0.11}As (aluminum gallium indium arsenide) and a barrier layer of Al_{0.2}Ga_{0.8}As are alternately laminated (See FIG. 6).

The upper spacer layer 106 is laminated on the active layer 105 on the +Z side, and is a non-doped (Al_{0.4}Ga_{0.6})_{0.5}In_{0.5}P layer.

A part including the lower spacer layer 104, the active layer of 105 and the upper spacer layer 106 is also called as a resonator structure, and set to have an optical thickness of a wavelength including a half of the adjacent composition gradient layer. Meanwhile, the active layer 105 is arranged at the center of the resonator structure, which is a position corresponding to an antinode of a stationary wave distribution of an electric field, so as to obtain high induced emission probability.

The upper semiconductor DBR 107 is laminated on the upper spacer layer 106 on the +Z side, and includes 24 pairs of a low refraction index layer of pAl_{0.9}Ga_{0.1}As and a high refraction index layer of p-Al_{0.3}Ga_{0.7}As.

Composition gradient layers are provided between the respective refraction index layers. Then, the respective refraction index layers are set to have an optical thickness of λ/4 including a half of the adjacent composition gradient layer.

In one of the lower refraction index layers in the upper semiconductor DBR 107, a selected oxide layer 108 of p-AlAs having a thickness of 30 nm is inserted. A position where the selected oxide layer 108 is inserted is a position which is separated from the upper spacer layer 106 by an optical distance of λ/4.

The contact layer 109 is laminated on the upper semiconductor DBR 107 on the +Z side, and is a layer of p-GaAs.

The protection film 111 is a film of SiO₂ or SiN.

The upper electrode 113 is electrically coupled to an electrode pad by a wiring member.

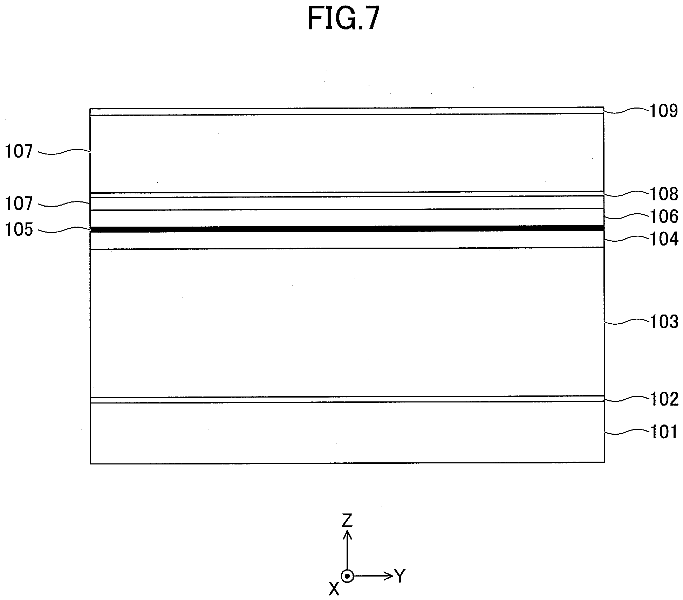

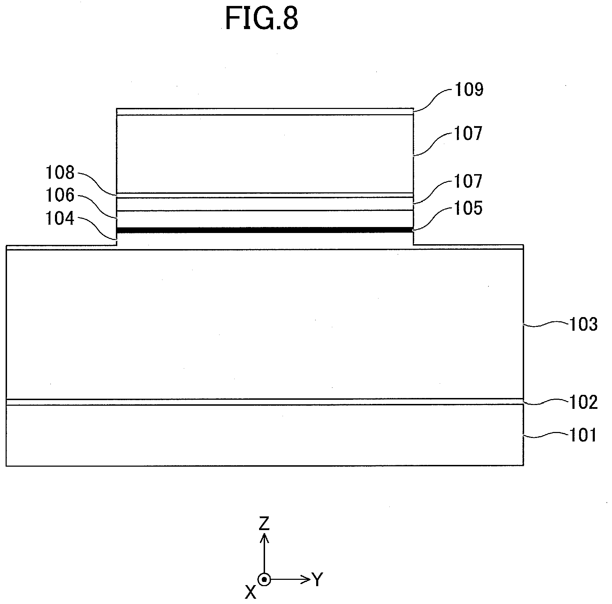

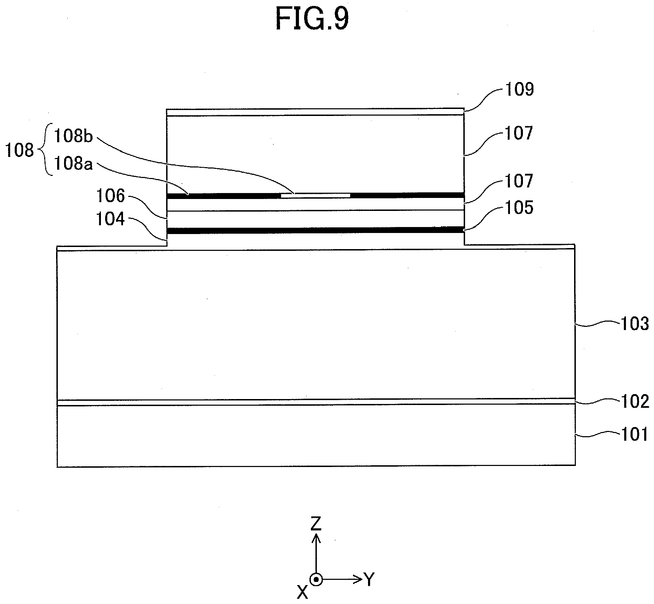

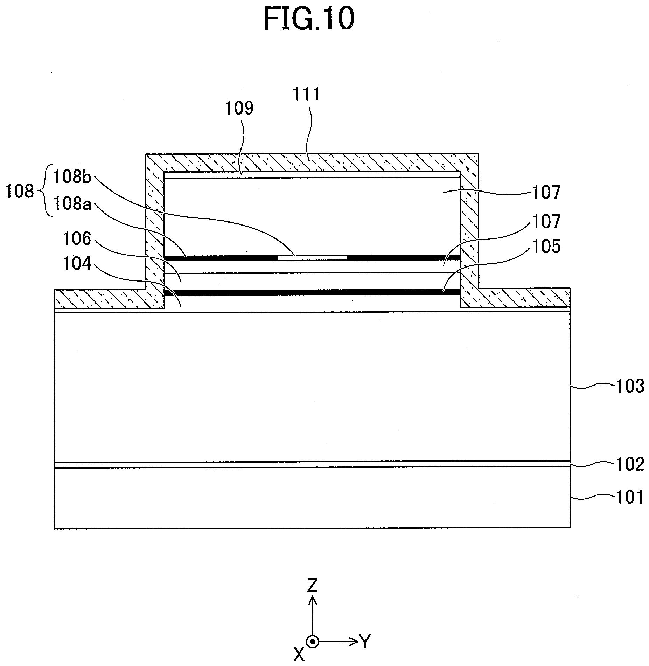

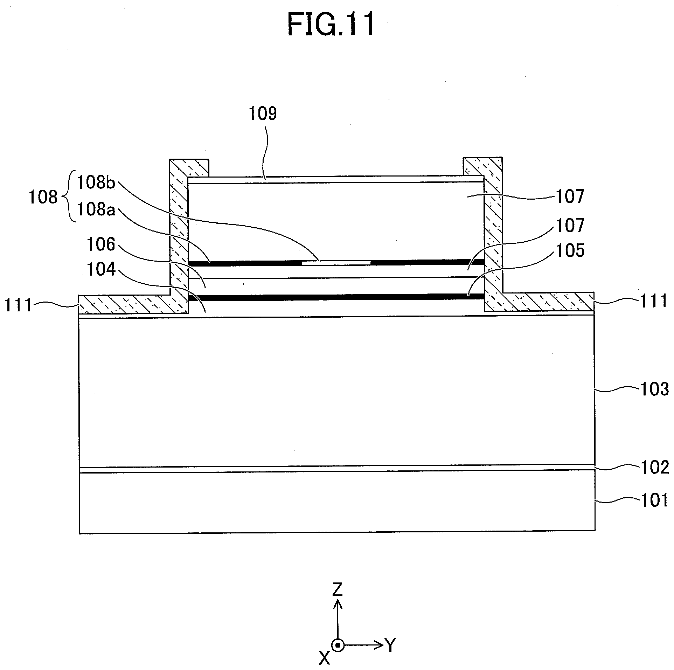

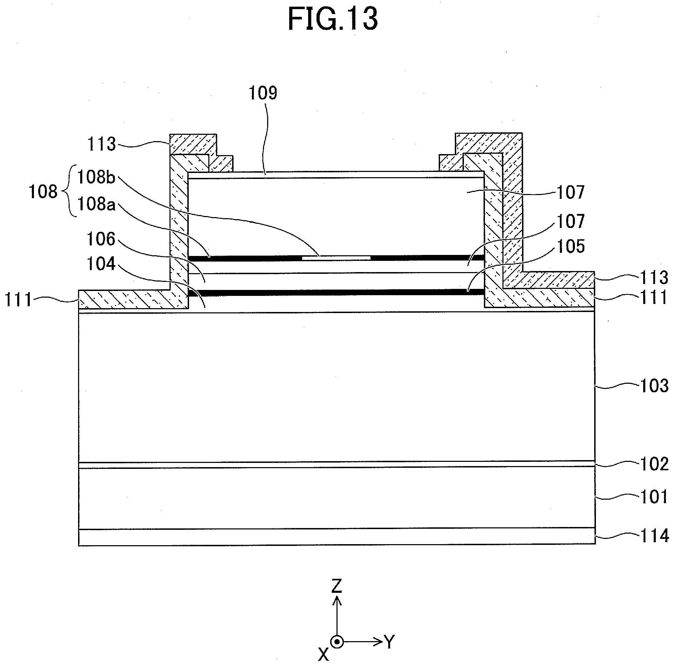

Next, a manufacturing method of the surface-emitting laser array 201 will be described.
(1) The buffer layer 102, the lower semiconductor DBR 103, the lower spacer layer 104, the active layer 105, the upper spacer layer 106, the upper semiconductor DBR 107, the selected oxide layer 108 and the contact layer 109 are formed on the substrate 101 according to crystal growth by using metalorganic chemical vapor deposition (MOCVD) method or the molecular beam epitaxy (MBE) method (See FIG. 7). Meanwhile, the plurality of semiconductor layers laminated on the substrate 101 as described above will be called "laminated body" for the sake of simplicity.
   As a group-III material, trimethyl aluminum (TMA), trimethyl gallium (TMG) or trimethyl indium (TMI) is used. As a group-V material, phosphine (PH₃) or arshin (AsH₃) is used. Moreover, as a material for the p-type dopant, carbon tetrabromide (CBr₄) or dimethyl zinc (DMZn) is used. As a material for n-type dopant, hydrogen selenide (H₂Se) is used.
   A resist pattern corresponding to a shape of mesa is formed on the surface of the laminated body. Specifically, photoresist is applied on the contact layer 109, exposure by an exposure device and developing are performed, and thereby the resist pattern corresponding to the shape of mesa is formed. Here, the mesa is formed to have a cross section of rectangular with a side of 20 µm to 25 µm. Meanwhile, as the resist applied on the contact layer 109, positive resist is used, and a contact exposure is performed.
   A mesa having a shape of quadratic prism is formed by dry etching such as reactive ion etching (RIE). Here, a bottom part of etching is positioned in the lower spacer layer 104. Meanwhile, by adjusting condition of dry etching, an inclination angle of a side face of the mesa can be adjusted. Here, the condition of dry etching is adjusted so that the inclination angle of the side of the mesa is 70° to 80° with respect to the surface of the substrate 101. In this case, a breaking of the wiring member is suppressed.
(4) The resist pattern is removed (See FIG. 8).
(5) The laminated body is subjected to heat treatment in steam. Here, Al in the selected oxide layer 108 is oxidized from a periphery of the mesa. Then, in the central part of the mesa, a region 108b which is not oxidized and surrounded by the oxide layer 108a of Al is caused to remain (See FIG. 9). Therefore, an oxidation narrowed structure, which restricts a path of a drive electric current for the light emitting part only to the central part of the mesa, is prepared. The above-described region 108a which is not oxidized is an electric current passing region (electric current injection region). Here, the electric current passing region 108b has an approximately rectangular shape with a side of about 5 µm.
(6) The protection film 111 of SiN is formed by using the plasma CVD method (See FIG. 10). It is preferable that a film thickness of the protection film 111 is from 150 nm to 200 nm, and is preferably 150 nm.
(7) A resist pattern for forming a contact hole is prepared on a top face of the mesa.
(8) The protection film 111 in an opening section of the resist pattern is removed by wet etching using buffered hydrofluoric acid (BHF).
(9) The resist pattern is removed (See FIG. 11).
(10) A resist pattern for masking a region other than regions where the upper electrode 113, the electrode pad and the wiring member are formed is prepared.
(11) A material of the upper electrode 113, the electrode pad and the wiring member is evaporated. Here, metal films of Cr (9 nm)/AuZn (18 nm)/Au (700nm) are laminated in series by EB (electron beam) deposition.
(12) By liftoff, a metal film on a region where the resist pattern is formed is removed. Therefore, the upper electrode 113, the electrode pad and the wiring member are formed (See FIG. 11).
(13) After polishing a back side of the substrate 101 until the thickness of the substrate 101 becomes 100 µm to 300 µm, metal films of Cr (9 nm)/AuGe (18 nm)/Au (250 nm) are laminated in series by EB (electron beam) deposition, to form the lower electrode 114 (See FIG. 13). Meanwhile, the thickness of the substrate 101 is preferably 100 µm.
(14) Annealing is performed at 400 °C for 5 minutes, to provide an ohmic conduction between the upper electrode 113 and the lower electrode 114. Therefore, the mesa becomes a light emitting part.
(15) The laminated body is divided into chips.

A surface-emitting laser array can be applied to a light source for excitation. For this purpose, a great gain of an active layer, a small threshold value and a high output power are required.

In a case of an oscillation wavelength of 800 nm band, for the active layer, three material combinations of GaAs/AlGaAs, GaInPAs/GaInP and AlGaInAs/AlGaAs can be used. It is reported that AlGaInAs/AlGaAs has a gain which is twice the other two material combinations (See Y. Zhang et al., "Design and comparison of GaAs, GaAsP and InGaAlAs quantum-well active regions for 808-nm VCSELs", Optics Express, Vol. 19, No. 13, pp. 12569-12581 (2011)).

In a case of using an As-based material for the active layer, a spacer layer generally includes AlₓGa₁₋ₓAs (See, for example, Japanese Unexamined Patent Application Publication No. 2013-191784). Since an Al composition x is normally great of about 0.5, impurities (especially, oxygen) is likely to be taken in during a crystal growth. These impurities become a cause of a non-emitting recombination of carriers upon a laser oscillation, and may decrease a light-emitting efficiency of laser or decrease reliability of a device.

In the surface-emitting laser array 201 according to the embodiment, each of the light emitting parts has a quantum well layer including (Al_{0.17}Ga_{0.83})_{0.89}In_{0.11}As, and uses (Al_{0.4}Ga_{0.6})_{0.5}In_{0.5}P that is a p-type material for the spacer layer. A difference between energy gaps ΔEg between the spacer layer and the quantum well layer is 544.4 meV. Meanwhile, in a case of using Al_{0.2}Ga_{0.8}As that is an As-based material with the same Al composition for the spacer layer, the difference between energy gaps ΔEg between the spacer layer and the quantum well layer is 67.4 meV.

That is, the surface-emitting laser array 201 according to the embodiment can perform a good carrier trapping with a small Al composition, and can enhance the light emitting efficiency.

As is clear from the above descriptions, in the ignition device 301 according to the embodiments, an "optical system for condensing laser light emitted from a laser device" in the ignition device of the present invention is configured with the emission optical system 210. Then, in the laser device 200 according to the embodiments, an "optical system for condensing laser light emitted from a surface-emitting laser array" in the laser device of the present invention is configured with the first condensing optical system 203, and a "transmission member" in the laser device of the present invention is configured with the optical fiber 204.

As described above, the surface-emitting laser array 201 according to the embodiments includes the plurality of light emitting parts. Each of the light emitting parts is a surface-emitting laser. The active layer 105 has a quantum well layer including (Al_{0.17}Ga_{0.83})_{0.89}In_{0.11}As and a barrier layer including Al_{0.2}Ga_{0.8}As. The lower space layer 104 and the upper spacer layer 106 include (Al_{0.4}Ga_{4.6})_{0.5}In_{0.5}P. In this case, the Al composition of the spacer layers can be reduced compared with the related art, and by reducing a non-emitting recombination electric current, the light emitting efficiency can be enhanced. Therefore, both a great gain of the active layer and a high light emitting efficiency can be achieved.

Meanwhile, the active layer only has to have a quantum well layer including (AlₓGa₁₋ₓ)_{y}In_{1-y}As (0≤x<1 and 0≤y<1) and a barrier layer including (AlₘGa₁₋ₘ)ₙIn₁₋ₙAs (0≤m<1 and 0≤n<1 where m≠x and n≠y).

Moreover, each of the spacer layer only has to include (AlₐGa₁₋ₐ)_{b}In_{1-b}P (0≤a<1 and 0≤b<1).

Moreover, in each of the light emitting parts, an inclined substrate is used for the substrate 101, and it is possible to decrease a three-dimensional growth and a crystal defect arising therefrom, which becomes a problem upon the growth of an AlGaInP layer.

Moreover, the laser device 200 can emit stably laser light at a high output power, due to the surface-emitting laser array 201.

Furthermore, the ignition device 301 can perform stable ignition due to the laser device 200.

Moreover, the engine 300 is provided with the ignition device 301, and as a result, the stability can be enhanced.

Moreover, in the embodiment, each of the first condensing optical system 203, the second condensing optical system 205 and the emission optical system 210 may be configured with a single lens or a plurality of lenses.

Moreover, in the embodiment, the case where the surface-emitting laser array 201 is used as a light source for excitation in the laser device 200 is described. However, this is not limiting. The surface-emitting laser array 201 may be used as a light source not for excitation in a laser device.

### «Laser annealing device»

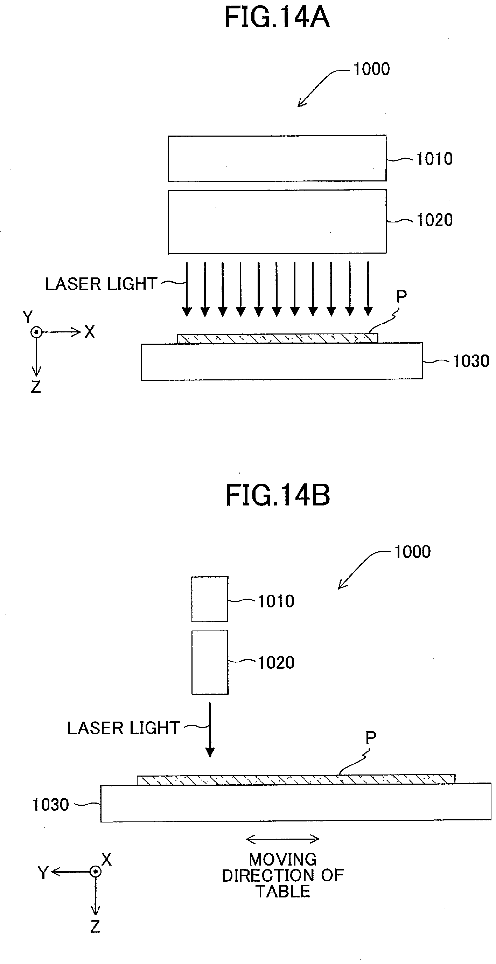

FIGs. 14A and 14B are diagrams schematically illustrating an example of a configuration of a laser annealing device 1000 as a laser device. The laser annealing device 1000 includes a light source 1010, an optical system 1020, a table device 1030, a control device, which is not shown, and the like.

The light source 1010 includes the surface-emitting laser array 201, and can emit a plurality of laser beams. The optical system 2010 guides the plurality of laser beams emitted from the light source 1010 onto a surface of an object P. The table device 1030 includes a table on which the object P is placed. The table is movable along at least a direction of the Y-axis.

For example, in a case where the object P is amorphous silicon (a-Si), temperature of the amorphous silicon (a-Si) irradiated with laser light rises. Thereafter, the amorphous silicon is gradually cooled to become poly-silicon (p-Si).

Moreover, since the light source 1010 includes the surface-emitting laser array 201, the laser annealing device 1000 can enhance processing efficiency.

### «Laser processing machine»

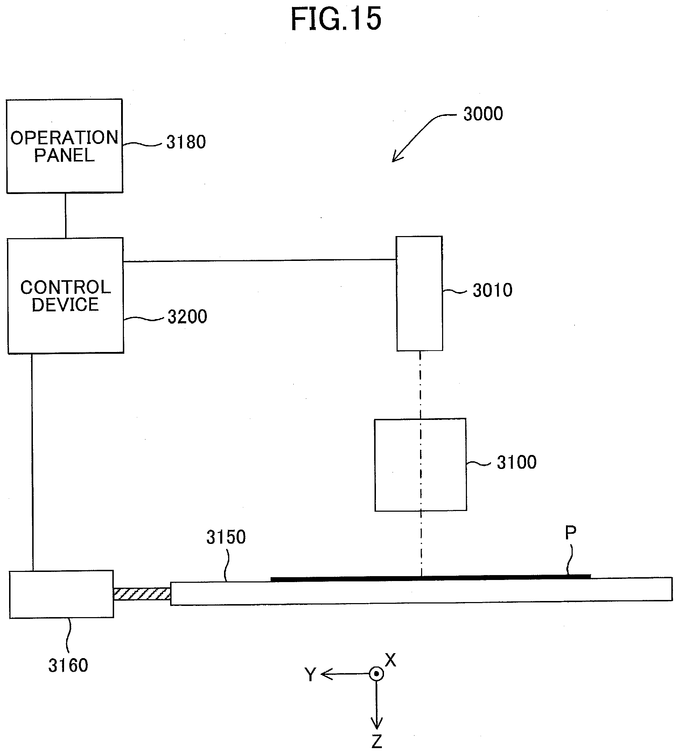

FIG. 15 is a diagram schematically illustrating an example of a configuration of a laser processing machine 3000 as a laser device. The laser processing machine 3000 includes a light source 3010, an optical system 3100, a table 3150 on which an object P is placed, a table driving device 3160, an operation panel 3180, a control device 3200 and the like.

The light source 3010 includes the surface emitting laser array 201, and emits laser light based on an instruction from the control device 3200. The optical system 3100 condenses laser light emitted from the light source 3010 at a point adjacent to a surface of the object P. The table driving device 3160 moves the table 3150 in directions of the X-axis, Y-axis and Z-axis based on an instruction from the control device 3200.

The operation panel 3180 includes a plurality of keys for an operator performing various settings, and an indicator for displaying various information. The control device 3200 controls the light source 3010 and the table driving device 3160 based on the various setting information from the operation panel 3180.

Then, since the light source 3010 includes the surface-emitting laser array 201, the laser processing machine 3000 can enhance processing efficiency (e.g. cutting or welding).

Meanwhile, the laser processing machine may include a plurality of light sources 3010.

Moreover, the surface-emitting laser array 201 is also preferable for a device using laser light, other than the laser annealing device and the laser processing machine. For example, the surface-emitting laser array 201 may be used as a light source of a display device.

Although the present invention has been described with reference to embodiments, the present invention is not limited to these embodiments, but various variations and modifications may be made without departing from the scope of the invention as set forth in the accompanying claims.

## Claims

1. A surface-emitting laser comprising:
a plurality of semiconductor layers;
an active layer (105), including a first layer including aluminum gallium indium arsenide, (AlₓGa₁₋ₓ)_{y}In_{1-y}As, where 0 < x < 1 and 0 < y < 1, and a second layer including aluminum gallium indium arsenide, (AlₘGa₁₋ₘ)ₙIn₁₋ₙAs, where 0 < m < 1 and 0 < n < 1, or aluminium gallium arsenide, (AlₘGa₁₋ₘ)As with 0<m<1, , and at least one of m≠x and n≠y is satisfied; and
spacer layers (104, 106) between which the active layer (105) is held, including aluminum gallium indium phosphide (AlₐGa₁₋ₐ)_{b}In_{1-b}P, where 0 < a < 1 and 0 < b < 1, or gallium indium phosphide, Ga_{b}In_{1-b}P where 0< b <1, the plurality of semiconductor layers and the active layer (105) held between the spacer layers (104, 106) being laminated; wherein the plurality of semiconductor layers are laminated on a substrate (101), and
wherein a normal direction of a surface of the substrate (101) is inclined with respect to one direction of a crystal orientation <1 0 0> toward one direction of a crystal orientation <1 1 1 >, and
wherein the first layer is a quantum well layer and the second layer is a barrier layer.

2. The surface-emitting laser according to claim 1, wherein an oscillation wavelength is 808 nm.

3. The surface-emitting laser according to any one of claims 1 to 2, wherein the substrate includes gallium arsenide (GaAs).

4. A surface-emitting laser array comprising the surface-emitting laser according to any one of claims 1 to 3.

5. A laser device for irradiating an object with laser light comprising:
the surface-emitting laser array according to claim 4 ; and
an optical system configured to guide the laser light emitted from the surface-emitting laser array to the object.

6. A laser device comprising:
the surface-emitting laser array according to claim 4;
an optical system configured to condense the laser light emitted from the surface-emitting laser array; and
a transmission member configured to transmit the laser light condensed by the optical system.

7. A laser device comprising:
the surface-emitting laser array according to claim 4 ; and
a laser resonator configured to receive the laser light emitted from the surface-emitting laser array.

8. The laser device according to claim 7, wherein the laser resonator is a Q switch laser.

9. The laser device according to claim 8,
wherein the laser resonator includes a laser medium and a saturable absorber.

10. An ignition device comprising:
the laser device according to any one of claims 7 to 9; and
an optical system configured to condense laser light emitted from the laser device.

11. An internal combustion engine for combusting fuel to generate a combustion gas comprising:
the ignition device for igniting the fuel according to claim 10.

## Patentansprüche

1. Oberflächenemittierender Laser, der Folgendes umfasst:
eine Vielzahl von Halbleiterschichten;
eine aktive Schicht (105),
einschließlich einer ersten Schicht, die Aluminium-Gallium-Indiumarsenid, (AlₓGa₁₋ₓ)_{y}ln_{1-y}As umfasst, wobei 0 < x < 1 und 0 < y < 1, und einer zweiten Schicht, die Aluminium-Gallium-Indiumarsenid, (AlₘGa₁₋ₘ)ₙln₁₋ₙAs, wobei 0 < m < 1 und 0 < n < 1, oder Aluminium-Gallium-Arsenid, (AlₘGa₁₋ₘ)As, wobei 0 < m < 1, umfasst, und wobei mindestens eines von m ≠ x und n ≠ y erfüllt ist; und Abstandsschichten (104, 106), zwischen denen die aktive Schicht (105) gehalten wird, einschließlich Aluminium-Gallium-Indium-Phosphid (AlₐGa₁₋ₐ)_{b}In_{1-b}P, wobei 0 < a < 1 und 0 < b < 1 oder Gallium-Indium-Phosphid, Ga_{b}In_{1-b}P wobei 0 < b < 1, wobei die Mehrzahl von Halbleiterschichten und die aktive Schicht (105), die zwischen den Abstandsschichten (104, 106) gehalten werden, laminiert ist; wobei die Mehrzahl von Halbleiterschichten auf ein Substrat (101) laminiert ist, und
wobei eine senkrechte Richtung einer Oberfläche des Substrats (101) in Bezug auf eine Richtung einer Kristallorientierung <1 0 0> in Richtung einer Richtung einer Kristallorientierung <1 1 1> geneigt ist, und
wobei die erste Schicht eine Quantentopfschicht ist und die zweite Schicht eine Sperrschicht ist.

2. Oberflächenemittierender Laser nach Anspruch 1,
wobei eine Oszillationswellenlänge 808 nm beträgt.

3. Oberflächenemittierender Laser nach einem der Ansprüche 1 bis 2,
wobei das Substrat Galliumarsenid (GaAs) umfasst.

4. Oberflächenemittierende Laseranordnung, die den oberflächenemittierenden Laser nach einem der Ansprüche 1 bis 3 umfasst.

5. Laservorrichtung zur Bestrahlung eines Objekts mit Laserlicht, die Folgendes umfasst:
die oberflächenemittierende Laseranordnung nach Anspruch 4; und
ein optisches System, das dafür konfiguriert ist, das von der oberflächenemittierenden Laseranordnung emittierte Laserlicht auf das Objekt zu lenken.

6. Laservorrichtung, die Folgendes umfasst:
die oberflächenemittierende Laseranordnung nach Anspruch 4;
ein optisches System, das dafür konfiguriert ist, das von der oberflächenemittierenden Laseranordnung emittierte Laserlicht zu bündeln; und
ein Übertragungselement, das dafür konfiguriert ist, das durch das optische System kondensierte Laserlicht zu übertragen.

7. Laservorrichtung, die Folgendes umfasst:
die oberflächenemittierende Laseranordnung nach Anspruch 4; und
einen Laserresonator, der dafür konfiguriert ist, das von der oberflächenemittierenden Laseranordnung emittierte Laserlicht zu empfangen.

8. Laservorrichtung nach Anspruch 7,
wobei der Laserresonator ein Q-Switch-Laser ist.

9. Laservorrichtung nach Anspruch 8,
wobei der Laserresonator ein Lasermedium und einen sättigungsfähigen Absorber umfasst.

10. Zündvorrichtung, die Folgendes umfasst:
die Laservorrichtung nach einem der Ansprüche 7 bis 9; und
ein optisches System, das dafür konfiguriert ist, das von der Laservorrichtung emittierte Laserlicht zu bündeln.

11. Verbrennungsmotor zur Verbrennung von Kraftstoff zur Erzeugung eines Verbrennungsgases, der Folgendes umfasst:
die Zündvorrichtung zum Zünden des Kraftstoffs nach Anspruch 10.

## Revendications

1. Laser à émission de surface comprenant :
une pluralité de couches semi-conductrices ;
une couche active (105), comprenant une première couche comprenant de l'arséniure d'aluminium gallium indium, (AlₓGa₁₋ₓ)_{y}In_{1-y}As, où 0<x<1 et 0<y<1, et une seconde couche comprenant de l'arséniure d'aluminium gallium indium, (AlₘGa₁₋ₘ)ₙIn₁₋ₙAs, où 0<m<1 et 0<n<l, ou de l'arséniure d'aluminium gallium, (AlₘGa₁₋ₘ)As avec 0<m<1, et au moins l'un de m≠x et n≠y est satisfait ; et
des couches d'espacement (104, 106) entre lesquelles la couche active (105) est maintenue, comprenant du phosphure d'aluminium gallium indium (AlₐGa₁₋ₐ)_{b}In_{1-b}P, où 0<a<1 et 0<b<1, ou du phosphure de gallium indium, Ga_{b}In_{1-b}P où 0<b<l, la pluralité de couches semi-conductrices et la couche active (105) maintenues entre les couches d'espacement (104, 106) étant laminées ;
dans lequel la pluralité de couches semi-conductrices sont stratifiées sur un substrat (101), et dans lequel une direction normale d'une surface du substrat (101) est inclinée par rapport à une direction d'une orientation cristalline <1 0 0> vers une direction d'une orientation cristalline <1 1 1>, et
dans lequel la première couche est une couche de puits quantique et la seconde couche est une couche barrière.

2. Laser à émission de surface selon la revendication 1, dans lequel une longueur d'onde d'oscillation est de 808 nm.

3. Laser à émission de surface selon l'une quelconque des revendications 1 à 2, dans lequel le substrat comprend de l'arséniure de gallium (GaAs).

4. Réseau laser à émission de surface comprenant le laser à émission de surface selon l'une quelconque des revendications 1 à 3.

5. Dispositif laser pour irradier un objet avec une lumière laser comprenant :
le réseau laser à émission de surface selon la revendication 4 ; et
un système optique configuré pour guider la lumière laser émise par le réseau laser à émission de surface vers l'objet.

6. Dispositif laser comprenant :
le réseau laser à émission de surface selon la revendication 4 ;
un système optique configuré pour condenser la lumière laser émise par le réseau laser à émission de surface ; et
un élément de transmission configuré pour transmettre la lumière laser condensée par le système optique.

7. Dispositif laser comprenant :
le réseau laser à émission de surface selon la revendication 4 ; et
un résonateur laser configuré pour recevoir la lumière laser émise par le réseau laser à émission de surface.

8. Dispositif laser selon la revendication 7, dans lequel le résonateur laser est un laser à commutateur Q.

9. Dispositif laser selon la revendication 8, dans lequel le résonateur laser comprend un milieu laser et un absorbeur saturable.

10. Dispositif d'allumage comprenant :
le dispositif laser selon l'une quelconque des revendications 7 à 9 ; et
un système optique configuré pour condenser la lumière laser émise par le dispositif laser.

11. Moteur à combustion interne pour combustion de carburant pour générer un gaz de combustion comprenant :
le dispositif d'allumage pour allumer le carburant selon la revendication 10.
